# EUROPEAN PATENT SPECIFICATION

(11) **EP 2 687 363 B1**
(45) Date of publication and mention of the grant of the patent: **22.06.2016**
(21) Application number: 12758160.1
(22) Date of filing: 14.03.2012
(51) Int. Cl.: B32B 9/00, H01L 31/042

(54) **LAMINATED MOISTURE PROOF FILM**
LAMINIERTER FEUCHTIGKEITSBESTÄNDIGER FILM
FILM RÉSISTANT À L'HUMIDITÉ STRATIFIÉ

(30) Priority: 15.03.2011 JP 2011056621; 29.03.2011 JP 2011072838
(43) Date of publication of application: 22.01.2014
(73) Proprietor: Mitsubishi Plastics, Inc., Tokyo 100-8252 (JP)
(72) Inventor: AKAIKE, Osamu, Ushiku-shi, Ibaraki 300-1201 (JP); TAKAGI, Shigeharu, Ushiku-shi, Ibaraki 300-1201 (JP); AYA, Tetsuya, Ushiku-shi, Ibaraki 300-1201 (JP); NINOMIYA, Naoya, Ushiku-shi, Ibaraki 300-1201 (JP)
(74) Representative: Hoffmann Eitle
(86) International application number: PCT/JP2012/056596
(87) International publication number: WO 2012/124742

(56) References cited:
- WO-A1-2008/059925
- JP-A- 2010 272 762
- JP-A- 2010 272 762
- JP-A- 2011 001 484
- JP-A- 2011 031 434
- JP-B2- 4 261 680

## Description

### Technical Field

The present invention relates to a moisture proof laminated film, and more specifically, relates to a moisture proof laminated film capable of being favorably used as a surface protective member for a solar cell module.

### Background Art

A moisture proof film containing a resin film substrate having formed on the surface thereof an inorganic layer, such as silicon oxide, has been laminated with another resin film and used for various packaging purposes. In recent years, the film is being applied to new purposes including a substrate film used for a liquid crystal display device, a solar cell, an electromagnetic wave shield, a touch-sensitive panel, an organic device, such as an organic electroluminescence (EL) device, an organic TFT, an organic semiconductor sensor and an organic luminescence device, electronic paper, a film capacitor, an inorganic EL device, a color filter and the like, and a vacuum thermal insulating material.

In these purposes, the moisture proof laminated film is being demanded to have higher performance, and an excellent moisture proof laminated film that suffers from less deterioration in moisture proofness in long-term use or under high temperature condition has been developed.

Under the circumstances, for example, PTL 1 proposes a back surface protective member for a solar cell module, using a moisture proof film containing a resin sheet having an inorganic oxide vapor deposited thereon instead of a metal foil, and discloses a protective sheet for a solar cell module which is a laminated material containing a substrate layer having weather resistance and a cyclic polyolefin resin layer, in which a vapor-deposited film of an inorganic oxide is provided on one surface of the laminated material.

PTL 2 and 3 propose a laminate sheet having plural sheets of a moisture proof film containing a resin sheet having an inorganic oxide vapor-deposited thereon, and PTL 2 discloses a back surface protective sheet for a sola cell module, containing a first vapor deposition resin layer having a vapor deposition layer of a metal oxide on one surface thereof, an intermediate resin layer, and a second vapor deposition resin layer having a vapor deposition layer of a metal oxide on one surface thereof, the layers being laminated through a dry lamination process, in which the vapor deposition layers of the first vapor deposition resin layer and the second vapor deposition resin layer are disposed on the side of the intermediate resin layer. PTL 3 discloses a method for producing a back surface protective sheet for a sola cell module, by laminating through a dry lamination process at least three layers of vapor deposition resin layers each having a vapor deposition layer of a metal oxide on one surface thereof, in which the vapor deposition resin layers each have a water vapor transmission rate of from 0.03 to 0.5 (g/m²·day) at 40°C and 90%RH.

PTL 4 discloses a moisture proof multilayer film having from 1 to 4 layer structures each containing two or more sheets of a composite film containing a nonhygroscopic resin layer having a vapor deposition layer of an inorganic oxide or a metal on at least one surface thereof, in which the vapor deposition layer surface of the composite film is laminated on the vapor deposition layer surface of the other composite film through an adhesive layer.

### Citation List

### Patent Literatures

PTL 1: JP-A-2001-44472
PTL 2: JP-A-2010-272761
PTL 3: JP-A-2010-272762
PTL 4: Japanese Patent No. 4,261,680

### Summary of Invention

### Technical Problems

In the production of a moisture proof laminated film having a multilayer structure formed of resin sheets, a dry lamination process is generally employed as an adhesion method between layers for preventing interlayer delamination. The dry lamination process is a lamination method of using a reactive adhesive for adhering layers to be laminated, in which firm adhesion between layers is obtained, but bubbles mainly containing carbon dioxide may be formed associated with reaction of the reactive adhesive. The bubbles formed between the layers are generally released outside through the interior of the layer formed of a resin sheet, and thus the bubbles formed between the layers may spontaneously disappear by providing a suitable aging period after the lamination.

However, in the case where a plurality of moisture proof films containing a resin sheet having a thin layer formed of an inorganic thin layer laminated thereon are laminated, bubbles formed between the layers may not permeate the inorganic thin layer formed of an inorganic oxide and may remain between the layers, particularly between the layers facing the inorganic thin layer of the moisture proof film. In this case, the inorganic thin layer may be cracked by the influence of stress due to the presence of the bubble, which may be a factor of decreasing the moisture proofness. Particularly, in the case where plural high moisture proof films having a low water vapor transmission rate are used as moisture proof laminated films for providing a high moisture proof capability, and the high moisture proof films are laminated, there is a conspicuous tendency of forming bubbles due to the residual solvent. Accordingly, it is difficult to enhance the moisture proofness of the obtained moisture proof laminated film only by laminating plural high moisture proof films. Thus, the protective materials, the multilayer sheets and the like disclosed in PTL 1 to 4 are insufficient in moisture proofness.

On performing a dry lamination process of moisture proof films having high moisture proofness, it is necessary to perform a process step of coating and drying an adhesive on at least one of the high moisture proof films, and a small amount of defects due to scratch, wear, load and the like on the surface of the inorganic thin layer in the process step may occur within the inorganic thin layer or between the moisture proof film substrate, the anchor coating layer and the inorganic thin layers. The defects exert severe influence on the moisture proofness, and therefore, the moisture proofness of the moisture proof laminated film thus formed may be impaired in quality and reliability only by laminating high moisture proof films through a dry lamination process.

In the field of solar cells, examples of a solar cell device include a single crystal silicon type, a polycrystalline silicon type, an amorphous silicon type, a III-V Group or II-VI Group compound semiconductor type, such as gallium-arsenic, copper-indium-selenium and cadmium-tellurium, a dye sensitization type and an organic thin layer type. While a moisture proof film having a water vapor transmission rate of up to approximately 0.1 (g/m²·day) is used as a surface protective member of an ordinary crystalline silicon solar cell device, solar cell devices of a semiconductor type, a dye sensitization type, an organic thin layer type and the like require a high moisture proof surface protective member having a water vapor transmission rate of 0.01 (g/m²·day) or less, and thus there is a demand of a high moisture proof laminated film with prevention of generation of bubbles between the layers.

### Solution to Problems

The present invention has been made under the circumstances, and is to provide high moisture proofness of a moisture proof laminated film while preventing retention of a solvent and generation of bubbles between moisture proof films by combining a moisture proof film having high moisture proofness and a moisture proof film having relatively low moisture proofness, and to enhance the handleability and the quality of a moisture proof laminated film by using a moisture proof film having relatively low moisture proofness.

Accordingly, the present invention relates to:
(1) a moisture proof laminated film comprising a moisture proof film A having a water vapor transmission rate (WTR (A)) at 40°C and 90%RH of 1.0 (g/m²·day) or less and a moisture proof film B comprising a substrate having on one surface thereof an inorganic layer and having a water vapor transmission rate (WTR (B)) at 40°C and 90%RH of 10% or less of the water vapor transmission rate (WTR (A)), which are laminated through an adhesive layer;
(2) a moisture proof laminated film comprising a moisture proof film A having a water vapor transmission rate (WTR (A)) at 40°C and 90%RH of 0.1 (g/m²·day) or more and 1.0 (g/m²·day) or less and a moisture proof film B comprising a substrate having on one surface thereof an inorganic layer and having a water vapor transmission rate (WTR (B)) at 40°C and 90%RH of 0.001 (g/m²·day) or more and less than 0.1 (g/m²·day), which are laminated through an adhesive layer;
(3) the moisture proof laminated film according to the item (1) or (2) , wherein the moisture proof laminated film has a water vapor transmission rate (WVTR (L)) at 40°C and 90%RH that is lower than a value ((WTR (A)) × (WTR (B))) / ((WTR (A)) + (WTR (B)));
(4) the moisture proof laminated film according to any one of the items (1) to (3), wherein the moisture proof laminated film has a water vapor transmission rate (WVTR (L)) at 40°C and 90%RH that is 80% or less of a value ((WTR (A)) × (WTR (B))) / ((WTR (A)) + (WTR (B)));
(5) the moisture proof laminated film according to any one of the items (1), (3) and (4), wherein the water vapor transmission rate (WTR (A)) at 40°C and 90%RH of the moisture proof film A is 0.1 (g/m²·day) or more;
(6) the moisture proof laminated film according to any one of the items (1) to (5), wherein the water vapor transmission rate (WTR (A)) at 40°C and 90%RH of the moisture proof film A is 0.2 (g/m²·day) or more;
(7) the moisture proof laminated film according to any one of the items (1) to (6), wherein the water vapor transmission rate (WTR (A)) at 40°C and 90%RH of the moisture proof film A is 0.4 (g/m²·day) or more;
(8) the moisture proof laminated film according to any one of the items (1) to (7), wherein the water vapor transmission rate (WTR (A)) at 40°C and 90%RH of the moisture proof film A is 0.6 (g/m²·day) or more;
(9) the moisture proof laminated film according to any one of the items (1) and (3) to (8), wherein the water vapor transmission rate (WTR (B)) at 40°C and 90%RH of the moisture proof film B is 0.001 (g/m²·day) or more and 0.1 (g/m²·day) or less;
(10) the moisture proof laminated film according to any one of the items (1) to (9), wherein the water vapor transmission rate (WTR (B)) at 40°C and 90%RH of the moisture proof film B is 0.001 (g/m²·day) or more and 0.05 (g/m²·day) or less;
(11) the moisture proof laminated film according to any one of the items (1) to (10), wherein the moisture proof film A has at least one layer containing a resin composition containing a cyclic olefin polymer;
(12) the moisture proof laminated film according to any one of the items (1) to (10), wherein the moisture proof film A comprises a substrate having on one surface thereof an inorganic layer;
(13) the moisture proof laminated film according to the item (12), wherein the moisture proof laminated film comprises a weather resistant film, the moisture proof film B and the moisture proof film A in this order from an exposure side, and the substrate of the moisture proof film B is disposed on a side of the inorganic layer of the moisture proof film A;
(14) the moisture proof laminated film according to the item (12), wherein the moisture proof laminated film comprises a weather resistant film, the moisture proof film A and the moisture proof film B in this order from an exposure side, and the substrate of the moisture proof film A is disposed on a side of the inorganic layer of the moisture proof film B;
(15) the moisture proof laminated film according to any one of the items (1) to (14), wherein the adhesive layer contains an adhesive, and the adhesive contains as a main agent at least one of a polycarbonate polyol, a polyether polyol, an acrylic polyol, a polyurethane polyol and a polyester polyol;
(16) the moisture proof laminated film according to any one of the items (1) to (15), which is used as a surface protective member for a solar cell;
(17) the moisture proof laminated film according to any one of the items (1) to (16), which is used as a surface protective member for a solar cell module having a compound power generating device or a flexible solar cell module;
(18) a surface protective member for a solar cell, containing the moisture proof laminated film according to any one of the items (1) to (17);
(19) the surface protective member for a solar cell according to the item (18), wherein the moisture proof film A and the moisture proof film B each have an inorganic layer on an exposure side; and
(20) a solar cell module produced by using the surface protective member for a solar cell according to the item (18) or (19).

### Advantageous Effects of Invention

According to the present invention, such a moisture proof laminated film is provided that is excellent in transparency, has considerably high moisture proofness, and is capable of suppressing the amount of bubbles formed between the moisture proof films, even when plural moisture proof films are used, and in particular, a moisture proof laminated film capable of being used as a surface protective member for a solar cell module and a surface protective member for a solar cell containing the moisture proof laminated film are provided.

### Brief Description of the Drawings

[Fig. 1]

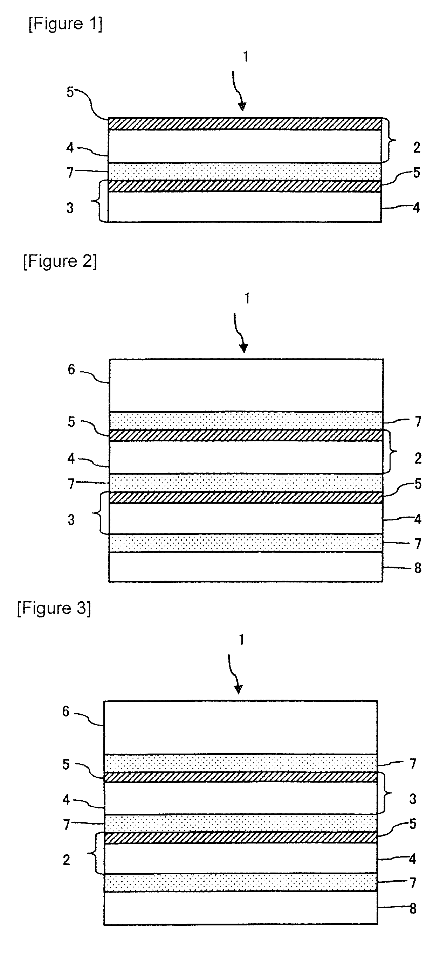

   Fig. 1 is a schematic cross sectional view showing a moisture proof laminated film according to one embodiment of the present invention.
[Fig. 2]
   Fig. 2 is a schematic cross sectional view showing a moisture proof laminated film according to an embodiment that is different from the moisture proof laminated film shown in Fig. 1.
[Fig. 3]
   Fig. 3 is a schematic cross sectional view showing a moisture proof laminated film according to an embodiment that is different from the moisture proof laminated films shown in Figs. 1 and 2.

### Description of Embodiments

The present invention will be described in detail below. In the present invention, the expression "X or more and Y or less" may be shown by "from X to Y" in some cases.

In general, a moisture proof laminated film is produced by a dry lamination process or the like. In the dry lamination process of a moisture proof film having an inorganic layer and a resin film, an adhesive having been diluted with a solvent is coated on the resin film to a prescribed thickness, and the solvent is evaporated by drying, for example, at a temperature in a range of from 100 to 140°C, to form an adhesive layer on the resin film. Thereafter, the surface of the inorganic layer of the moisture proof film is made to face the adhesive and is adhered thereto, and the assembly is subjected to aging at a prescribed temperature, thereby producing the moisture proof laminated film. The aging is performed, for example, at a temperature in a range of from 30 to 80°C for from one day to one week.

In the case where high moisture proof films are subjected to the dry lamination process, in general, the solvent contained in the adhesive coating composition in the dry lamination process is difficult to diffuse from the inside to the outside of the laminated film and is difficult to evaporate from the surface thereof due to the high moisture proofness of the high moisture proof films. Accordingly, the solvent may remain inside the laminated film, and bubbles may significantly formed under heating.

The present inventors have found that a moisture proof laminated film that does not undergo generation of bubbles on heating and is excellent in transparency and moisture proofness may be obtained by laminating a film having relatively low moisture proofness with a high moisture proof film having an inorganic layer on one surface thereof and having a water vapor transmission rate at 40°C and 90%RH of 10% or less of that of the film having relatively low moisture proofness, through an adhesive layer by a dry lamination process or the like. The inventors have also found that a moisture proof laminated film that does not undergo generation of bubbles on heating and is excellent in transparency and moisture proofness may be obtained by laminating a moisture proof film having relatively low moisture proofness having a water vapor transmission rate at 40°C and 90%RH of 0.1 (g/m²·day) or more and 1.0 (g/m²·day) or less with a high moisture proof film containing a substrate having on one surface thereof an inorganic layer and having a water vapor transmission rate at 40°C and 90%RH of 0.001 (g/m²·day) or more and less than 0.1 (g/m²·day), by a dry lamination process or the like.

It is considered that this is because in the aforementioned constitutions, the solvent in the adhesive coating composition may relatively easily permeate the film having low moisture proofness and may evaporate outside the moisture proof laminated film, and thus the solvent may not remain therein.

In the moisture proof laminated film, in which the moisture proof film having high moisture proofness is used as an outer layer at 40°C and 90%RH, which is the measurement environment of the moisture proofness, penetration of water vapor to the moisture proof laminated film may be prevented with the moisture proof film having high moisture proofness, and on the surface of the inorganic thin layer of the moisture proof film having relatively low moisture proofness on the inner side, a low humidity condition may be formed as compared to the measurement environment of the moisture proofness. The low humidity condition may considerably reduce the water adsorption on the moisture proof film having relatively low moisture proofness, and as a result, the water transmission through the moisture proof film having relatively low moisture proofness is reduced, thereby enhancing the moisture proofness of the moisture proof film.

In the case where the moisture proof film having relatively low moisture proofness is used as an outer layer, similarly, penetration of water vapor to the moisture proof laminated film may be prevented to some extent with the moisture proof film having relatively low moisture proofness, and on the surface of the inorganic thin layer of the moisture proof film having high moisture proofness on the inner side, a low humidity condition may be formed as compared to the measurement environment of the moisture proofness. The low humidity condition may considerably reduce the water adsorption on the inorganic layer surface of the moisture proof film having high moisture proofness, and as a result, the water transmission through the moisture proof film having high moisture proofness is reduced, thereby enhancing the moisture proofness of the moisture proof film. Consequently, a moisture proof laminated film excellent in moisture proofness may be obtained.

### Moisture Proof Laminated Film

The moisture proof laminated film of the present invention contains a moisture proof film A having a water vapor transmission rate (WTR (A)) at 40°C and 90%RH of 1.0 (g/m²·day) or less and a moisture proof film B containing a substrate having on one surface thereof an inorganic layer and having a water vapor transmission rate (WTR (B)) at 40°C and 90%RH of 10% or less of the water vapor transmission rate (WTR (A)), and the moisture proof film A and the moisture proof film B are laminated through an adhesive layer.

The moisture proof laminated film as another embodiment of the present invention contains a moisture proof film A having a water vapor transmission rate (WTR (A)) at 40°C and 90%RH of 0.1 (g/m²·day) or more and 1.0 (g/m²·day) or less and a moisture proof film B containing a substrate having on one surface thereof an inorganic layer and having a water vapor transmission rate (WTR (B)) at 40°C and 90%RH of 0.001 (g/m²·day) or more and less than 0.1 (g/m²·day), which are laminated through an adhesive layer.

The constitutional layers will be described below.

### Moisture Proof Film A

The moisture proof film A in the moisture proof laminated film of the present invention has a water vapor transmission rate (WTR (A)) at 40°C and 90%RH of 1.0 (g/m²·day) or less. For preventing the solvent in the adhesive coating composition from remaining in the combination of the moisture proof film A and the moisture proof film B in the present invention, the water vapor transmission rate (WTR (A)) at 40°C and 90%RH of the moisture proof film A is preferably 0.1 (g/m²·day) or more, more preferably 0.2 (g/m²·day) or more, further preferably 0.4 (g/m²·day) or more, and particularly preferably 0.6 (g/m²·day) or more. When the water vapor transmission rate (WTR (A)) of the moisture proof film A is in the range, the solvent easily permeates the moisture proof film A to prevent generation of bubbles on heating from occurring even though the moisture proof laminated film has high moisture proofness.

Examples of the moisture proof film A include a moisture proof resin film and a film containing a substrate having on one surface thereof an inorganic layer.

Examples of the moisture proof resin film include a film having at least one layer containing a resin composition containing a cyclic olefin polymer (which may be hereinafter referred to as a "cyclic olefin polymer moisture proof film") . The content of the cyclic olefin polymer in the layer is preferably from 50 to 100% by mass.

The cyclic olefin polymer is excellent in water repellency and also in coating property and environmental safety due to the main skeleton thereof formed of carbon, and thus is preferably used in the moisture proof film A of the present invention. Examples of the cyclic olefin polymer include the following three constitutions (A) to (C):
(A) : a cyclic olefin random copolymer containing a linear olefin component and a cyclic olefin component;
(B): a ring-opened polymer containing a cyclic olefin component, or a hydride thereof; and
(C): a mixture of (A) and (B).

Examples of the cyclic olefin component include bicyclohept-2-ene (2-norbornene) and derivatives thereof, such as norbornene, 6-methylnorbornene, 6-ethylnorbornene, 6-n-butylnorbornene, 5-propylnorbornene, 1-methylnorbornene, 7-methylnorbornene, 5,6-dimethylnorbornene, 5-phenylnorbornene and 5-benzylnorbornene.

The cyclic olefin random copolymer in the constitution (A) is a copolymer of a linear olefin component and the aforementioned cyclic olefin component, and is preferably used in the present invention from the standpoint of the flowability, the transparency, the water vapor barrier property and the like. Preferred examples of the linear olefin component that is copolymerized with the cyclic olefin component include an α-olefin having from 2 to 20 carbon atoms, such as ethylene, propylene, 1-butene, 1-pentene, 1-hexene, 1-heptene, 1-octene, 1-nonene, 1-decene, 3-methylbutene-1 and 4-methylpentene-1. In the present invention, ethylene is preferably used as the linear olefin component, and norbornene and tetracyclododecene are preferably used as the cyclic olefin component, from the standpoint of the industrial availability, the properties and the economy. The cyclic olefin component and the linear olefin component to be copolymerized may each be used solely or as a combination of two or more kinds thereof.

The content (% by mol) of the cyclic olefin component in the cyclic olefin random copolymer is not particularly limited, and in an ethylene-norbornene random copolymer, for example, the content of the norbornene component is preferably 1% by mol or more, more preferably 10% by mol or more, and further preferably 15% by mol or more, and is preferably 60% by mol or less, more preferably 40% by mol or less, and further preferably 30% by mol or less. The content thereof is preferably in the range since the melt viscosity, the mechanical characteristics, the economy and the like on using as a surface protective member for a solar cell may be excellent.

The cyclic olefin polymer used may be a commercially available product, such as Arton (trade name), produced by JSR Corporation, and Zeonex (trade name), produced by Nippon Zeon Corporation.

The cyclic olefin polymer generally has heat resistance and high transparency, and a film formed of a resin composition containing the cyclic olefin polymer may have a small water vapor transmission rate per unit area, and thus may be excellent water vapor barrier property.

The cyclic olefin polymer moisture proof film in the present invention may be produced, for example, by forming one kind or two or more kinds of the cyclic olefin polymers into a film by a such a film forming method as an extrusion method, a cast molding method, a T-die method, a cutting method, an inflation method or the like, by forming two or more kinds of the cyclic olefin polymers into a film by a multilayer co-extrusion method, or by forming two or more kinds of the cyclic olefin polymers into a film by such a method that the polymers are mixed before the formation of the film, and depending on necessity, the resulting cyclic olefin polymer moisture proof film may be stretched uniaxially or biaxially, for example, by a tenter method or a tubular method, thereby providing a uniaxially or biaxially stretched cyclic olefin polymer moisture proof film.

The thickness of the moisture proof resin film in the present invention is preferably from 12 to 700 µm, and more preferably from 25 to 500 µm, from the standpoint of the balance between the moisture proofness and the flexibility. The moisture proof resin film may have a visible ray transmittance of 85% or more, preferably 90% or more, and more preferably 92% or more, on using as a surface protective member for a solar cell, and thus preferably has such a property that transmits incident solar light for enhancing the electric power generation efficiency.

On forming the cyclic olefin polymer into a film, various resin compounding agents, additives and the like may be added for enhancing or modifying the processability, heat resistance, weather resistance, strength, mechanical properties, dimensional stability, antioxidative property, lubricating property, releasability, flame retardancy, antifungal property, electric characteristics, penetration resistance and the like, of the film, and the addition amount thereof may vary arbitrarily from a slight amount to several ten percents depending on the purpose thereof. Examples of the ordinary additives include a lubricant, a crosslinking agent, an antioxidant, an ultraviolet ray absorbent, a light stabilizing filler, an antistatic agent, a fire retardant, a flame retardant, a pigment and the like, and furthermore a modifying resin and the like may also be used.

In the present invention, the surface of the cyclic olefin moisture proof film may be arbitrarily subjected to a pretreatment, such as a corona discharge treatment, an ozone treatment, a low temperature plasma treatment using oxygen gas or nitrogen gas, a glow discharge treatment, an antioxidative treatment using a chemical agent or the like, and the like, and a primer coating layer, an undercoating layer, a vapor deposition anchor coating layer and the like may be formed arbitrarily on the surface of the cyclic olefin moisture proof film. The coating layers may be formed, for example, of a resin composition containing a polyester resin, a polyurethane resin or the like as a main agent of the vehicle. The coating layers may be formed by coating a coating composition of a solvent type, an aqueous type, an emulsion type or the like by such a coating method as a roll coating method, a gravure coating method, a kiss coating method or the like, and the timing for coating the layers may be after forming the cyclic polyolefin moisture proof film, as a post-process after the biaxial stretching, as an in-line process of the biaxial stretching on forming the film, or the like.

Examples of the moisture proof film A of the present invention also include a film containing a substrate having on one surface thereof an inorganic layer as described above. The inorganic layer protects an inner side of a solar cell from invasion of moisture. When the film having an inorganic layer having high transparency is used as a surface protective member, the electric power generation efficiency may be enhanced.

The substrate having the inorganic layer thereon is preferably a resin film, and any resin that may be used as an ordinary solar cell material may be used as the material therefor without particular limitation. Specific examples thereof include a polyolefin, such as a homopolymer or a copolymer of ethylene, propylene, butene and the like, an amorphous polyolefin, such as a cyclic polyolefin, a polyester, such as a polyethylene terephthalate (PET) and a polyethylene naphthalate (PEN), a polyamide, such as nylon 6, nylon 66, nylon 12 and a copolymer nylon, a partially hydrolyzed ethylene-vinyl acetate copolymer (EVOH), a polyimide, a polyetherimide, a polysulfone, a polyethersulfone, a polyether ether ketone, a polycarbonate, a polyvinyl butyral, a polyarylate, a fluorine resin, an acrylic resin and a biodegradable resin. Among them, a thermoplastic resin is preferred, and a polyester, a polyamide and a polyolefin are more preferred from the standpoint of the film property, the cost and the like. Among them, a polyester, such as a polyethylene terephthalate (PET) and a polyethylene naphthalate (PEN), is particularly preferred from the standpoint of the film property.

The substrate may contain a known additive, such as an antistatic agent, an ultraviolet ray absorbent, a plasticizer, a lubricant, a filler, a colorant, a stabilizer, such as a weather resistant stabilizer, a lubricating agent, a crosslinking agent, an antiblocking agent and an antioxidant.

Examples of the ultraviolet ray absorbent used include various commercially available products, examples of which include various types, such as a benzophenone series, a benzotriazole series, a triazine series and a salicylate ester series. Examples of the benzophenone ultraviolet ray absorbent include 2-hydroxy-4-methoxybenzophenone, 2-hydroxy-4-methoxy-2'-carboxybenzophenone, 2-hydroxy-4-octoxybenzophenone, 2-hydroxy-4-n-dodecyloxybenzophenone, 2-hydroxy-4-n-octadecyloxybenzophenone, 2-hydroxy-4-benzyloxybenzophenone, 2-hydroxy-4-methoxy-5-sulfobenzophenone, 2-hydroxy-5-chlorobenzophenone, 2,4-dihydroxybenzophenone, 2,2'-dihydroxy-4-methoxybenzophenone, 2,2'-dihydroxy-4,4'-dimethoxybenzophenone and 2,2',4,4'-tetrahydroxybenzophenone.

Examples of the benzotriazole ultraviolet ray absorbent include a hydroxyphenyl-substituted benzotriazole compound, such as 2-(2-hydroxy-5-methylphenyl)benzotriazole, 2-(2-hydroxy-5-t-butylphenyl)benzotriazole, 2-(2-hydroxy-3,5-dimethylphenyl)benzotriazole, 2-(2-methyl-4-hydroxyphenyl)benzotriazole, 2-(2-hydroxy-3-methyl-5-t-butylphenyl)benzotriazole, 2-(2-hydroxy-3,5-di-t-amylphenyl)benzotriazole and 2-(2-hydroxy-3,5-di-t-butylphenyl)benzotriazole. Examples of the triazine ultraviolet ray absorbent include 2-(4,6-bis(2,4-dimethylphenyl)-1,3,5-triazin-2-yl)-5-(octy loxy)phenol and 2-(4,6-diphenyl-1,3,5-triazin-2-yl)-5-(hexyloxy)phenol. Examples of the salicylate ester ultraviolet ray absorbent include phenyl salicylate and p-octylphenyl salicylate.

The amount of the ultraviolet ray absorbent added is generally approximately from 0.01 to 2.0% by mass, and preferably from 0.05 to 0.5% by mass, based on the substrate.

Preferred examples of the weather resistant stabilizer imparting weather resistance in addition to the ultraviolet ray absorbent include a hindered amine light stabilizer. A hindered amine light stabilizer does not absorb an ultraviolet ray, unlike the ultraviolet ray absorbent, but an outstanding synergistic effect may be exhibited on using in combination with an ultraviolet ray absorbent.

Examples of the hindered amine light stabilizer include a polycondensate of dimethyl succinate and 1-(2-hydroxyethyl)-4-hydroxy-2,2,6,6-tetramethylpiperidine, poly((6-(1,1,3,3-tetramethylbutyl)amino-1,3,5-triazine-2,4 -diyl)((2,2,6,6-tetramethyl-4-piperidyl)imino)hexamethylen e((2,2,6,6-tetramethyl-4-piperidyl)imino)), a polycondensate of N,N'-bis(3-aminopropyl)ethylenediamine and 2,4-bis(N-butyl-N-(1,2,2,6,6-pentamethyl-4-piperidyl)amino )-6-chloro-1,3,5-triazine, bis(2,2,6,6-tetramethyl-4-piperidyl) sebacate, and bis(1,2,6,6-pentamethyl-4-piperidyl) 2-(3,5-di-tert-butyl-4-hydroxybenzyl)-2-n-butylmalonate. The amount of the hindered amine light stabilizer added may be approximately from 0.01 to 0.5% by mass, and preferably from 0.05 to 0.3% by mass, based on the substrate.

The resin film as the substrate may be formed by molding the aforementioned materials, and the substrate used may be unstretched or stretched.

The substrate may be a laminated product of one or more kinds of resin films.

The substrate may be produced by a known method, and for example, an unstretched film that is substantially amorphous and unoriented may be produced by melting and extruding the raw material resin from a circular die or a T-die with an extruder, and then quenched. A single layer film formed of one kind of the resin, a multilayer film formed of one kind of the resin, a multilayer film formed of plural kinds of the resins, and the like may be produced by using a multilayer die.

The unstretched film may be stretched in the machine direction of the film (i.e., the longitudinal axis) or the direction perpendicular to the machine direction of the film (i.e., the transverse direction) by a known method, such as uniaxial stretching, tenter sequential biaxial stretching, tenter simultaneous biaxial stretching and tubular simultaneous biaxial stretching, thereby producing a uniaxially or biaxially stretched film. The stretching ratio may be arbitrarily determined, and the thermal shrinkage at 150°C is preferably from 0.01 to 5%, and more preferably from 0.01 to 2%. Among them, a biaxially stretched polyethylene naphthalate film, a biaxially stretched polyethylene terephthalate film, a biaxially stretched co-extruded film of polyethylene terephthalate and polyethylene naphthalate, and a biaxially stretched co-extruded film of polyethylene terephthalate and/or polyethylene naphthalate with another resin.

The thickness of the substrate is generally approximately from 5 to 100 µm, and is preferably from 8 to 50 µm, and more preferably from 12 to 25 µm, from the standpoint of the productivity and the handleability.

An anchor coating layer is preferably provided on the substrate by coating an anchor coating agent for enhancing the adhesion to the inorganic layer. Examples of the anchor coating agent include a solvent or aqueous polyester resin, an isocyanate resin, a urethane resin, an acrylic resin, a modified vinyl resin, an alcoholic hydroxyl group-containing resin, such as a vinyl alcohol resin, a vinyl butyral resin, a nitrocellulose resin, an oxazoline group-containing resin, a carbodiimide group-containing resin, a methylene group-containing resin, an epoxy group-containing resin, a modified styrene resin and a modified silicone resin. These may be used solely or as a combination of two or more kinds thereof. The anchor coating layer may contain a silane coupling agent, a titanium coupling agent, an ultraviolet ray absorbent, a stabilizer, such as a weather resistant stabilizer, a lubricant, an antiblocking agent and an antioxidant, depending on necessity.

Examples of the ultraviolet ray absorbent and the weather resistant stabilizer include those described for the substrate. A polymer type material, which is obtained by copolymerizing the ultraviolet ray absorbent and/or the weather resistant stabilizer with the aforementioned resin, may also be used.

The method for forming the anchor coating layer may be selected from known coating methods. For example, coating methods using a reverse roll coater, a gravure coater, a rod coater, an air doctor coater and a spray coater may be employed. The substrate may be immersed in a resin solution. After coating, the solvent may be evaporated by a known drying method, such as a heat drying method, e.g., hot air drying at a temperature of approximately from 80 to 200°C and heat roll drying, and an infrared ray drying method. The anchor coating layer may be crosslinked by irradiation with an electron beam for enhancing the water resistance and the durability. The formation of the anchor coating layer may be performed on the production line of the substrate (i.e., an in-line method) or after the production of the substrate (i.e., an off-line method).

The thickness of the anchor coating layer is preferably from 10 to 200 nm, and more preferably from 10 to 100 nm, from the standpoint of the adhesion to the inorganic layer.

The method for forming the inorganic layer may be such a method as a vapor deposition method and a coating method, and a vapor deposition method is preferred since a uniform thin layer having high gas barrier property may be obtained thereby. Examples of the vapor deposition method include a physical vapor deposition (PVD) method and a chemical vapor deposition (CVD) method. Examples of the physical vapor deposition method include vacuum vapor deposition, ion plating and sputtering, and examples of the chemical vapor deposition method include plasma CVD using plasma and catalytic chemical vapor deposition (Cat-CVD), in which a raw material gas is subjected to catalytic thermal decomposition with a heated catalyst.

Examples of the inorganic substance constituting the inorganic layer include silicon, aluminum, magnesium, zinc, tin, nickel, titanium and hydrogenated carbon, an oxide, a carbonate and a nitrate thereof, and mixtures thereof, and an inorganic oxide, such as silicon oxide, silicon oxynitride and aluminum oxide, a nitride, such as silicon nitride, and diamond-like carbon containing mainly hydrogenated carbon are preferred since no electric current leakage may occur on applying to a solar cell. In particular, silicon oxide, silicon nitride, silicon oxynitride and aluminum oxide are preferred since high gas barrier property may be stably maintained.

The thickness of the inorganic layer is preferably from 10 to 1,000 nm, more preferably from 40 to 1,000 nm, further preferably from 40 to 800 nm, and particularly preferably from 50 to 600 nm, for enhancing the moisture proof capability stably. The inorganic layer may have a single layer structure or a multilayer structure.

The thickness of the moisture proof film containing a substrate having on one surface thereof an inorganic layer is generally approximately from 5 to 100 µm, and is preferably from 8 to 50 µm, and further preferably from 12 to 25 µm, from the standpoint of the productivity and the handleability.

The water vapor transmission rate (WTR (A)) of the moisture proof film A may be controlled with the composition of the resin composition constituting the film, the kind of the resin and the thickness of the film in the case where the moisture proof film A is the moisture proof resin film. In the case where the moisture proof film A is the film containing a substrate having on one surface thereof an inorganic layer, the water vapor transmission rate (WTR (A)) thereof may be controlled with the selection of the materials constituting the substrate and the inorganic layer, the thickness of the inorganic layer, the oxidation number of an inorganic oxide for the inorganic layer that is constituted by the inorganic oxide, the total thickness of the moisture proof film A, and the like.

The moisture proofness of the moisture proof film A is determined by the extent of water diffusion in the moisture proof film A and the difference in water concentration between both surfaces of the moisture proof film A. In the present invention, in the case where the moisture proof film B having high moisture proofness is disposed on the exposure side, the moisture proofness of the moisture proof film A may be enhanced by suppressing water that penetrates toward the inner side to reduce the difference in water concentration between both surfaces of the moisture proof film A. In the case where the moisture proof film A is disposed on the exposure side, the moisture proofness of the moisture proof film B may be further enhanced by suppressing water that penetrates toward the inner side to reduce the difference in water concentration between both surfaces of the moisture proof film B.

### Moisture Proof Film B

The moisture proof film B in the present invention contains a substrate having on one surface thereof an inorganic layer and has a water vapor transmission rate (WTR (B)) at 40°C and 90%RH of 10% or less, preferably 5% or less, and more preferably 3% or less, of the value for the moisture proof film A. When the ratio is 10% or less, the resulting moisture proof laminated film has high moisture proofness, whereas the solvent in the adhesive coating composition penetrates relatively easily through the moisture proof film A and evaporates from the surface thereof outside the moisture proof laminated film without remaining, thereby preventing generation of bubbles on heating.

The water vapor transmission rate at 40°C and 90%RH of the moisture proof film B is preferably 0.1 (g/m²·day) or less, more preferably 0.05 (g/m²·day) or less, further preferably 0.03 (g/m²·day) or less, and particularly preferably 0.005 (g/m²·day) or less.

In another embodiment of the present invention, the moisture proof film B has a water vapor transmission rate (WTR (B)) of 0.001 (g/m²·day) or more and less than 0.1 (g/m²·day), preferably 0.001 (g/m²·day) or more and 0.05 (g/m²·day) or less, and further preferably 0.001 (g/m²·day) or more and 0.02 (g/m²·day) or less.

The inorganic layer protects an inner side of a solar cell from invasion of moisture. When the inorganic layer has high transparency, the electric power generation efficiency may be enhanced on using as a surface protective member.

The substrate and the inorganic layer constituting the moisture proof film B may be those described for the moisture proof film A. The anchor coating layer that has been described for the moisture proof film A may be preferably provided therefor.

The thickness of the inorganic layer is preferably from 10 to 1,000 nm, more preferably from 40 to 1,000 nm, further preferably from 40 to 800 nm, and particularly preferably from 50 to 600 nm, for exhibiting high moisture proofness and transparency. The inorganic layer may have a single layer structure or a multilayer structure.

The thickness of the substrate is generally approximately from 5 to 100 µm, and is preferably from 8 to 50 µm, and further preferably from 12 to 25 µm, from the standpoint of the productivity and the handleability. Accordingly, the thickness of the moisture proof film B is generally approximately from 5 to 100 µm, and is preferably from 8 to 50 µm, and further preferably from 12 to 25 µm, from the standpoint of the productivity and the handleability.

The water vapor transmission rate (WTR (B)) of the moisture proof film B may be controlled with the selection of the substrate, the selection of the material constituting the inorganic layer, the thickness of the inorganic layer, the oxidation number of an inorganic oxide for the inorganic layer that is constituted by the inorganic oxide, the total thickness of the moisture proof film B, and the like.

### Moisture Proof Laminated Film

The moisture proof laminated film of the present invention contains the moisture proof film A and the moisture proof film B, and preferably has a water vapor transmission rate (WVTR (L)) at 40°C and 90%RH that is lower than a value ((WTR (A)) × (WTR (B))) / ((WTR (A)) + (WTR (B))).

In a moisture proof laminated film formed by laminating plural moisture proof film with an adhesive, in the case where the adhesive used does not have a function of enhancing the moisture proofness of the moisture proof films, for example, reinforcing the defects on the surface of the inorganic layer, which are factors of deteriorating the moisture proofness of the moisture proof films, it is considered that the moisture proofness of the laminated film is derived serially from the contributions of the respective moisture proof films to the moisture proofness. Specifically, the water vapor transmission rate (W) at 40°C and 90%RH of the resulting moisture proof laminated film is expressed by 1/W = 1/ (WTR (A)) + 1/ (WTR (B)), and thus is theoretically obtained by W = ((WTR (A)) × (WTR (B))) / ((WTR (A)) + (WTR (B))).

The moisture proof laminated film of the present invention may have a water vapor transmission rate (WVTR (L)) that is lower than the theoretical value (WTR (A)) x (WTR (B))) / ((WTR (A)) + (WTR (B))), and thus is a moisture proof laminated film that is considerably excellent in moisture proofness. This means that the moisture proof laminated film of the present invention having a combination of a high moisture proof film and a low moisture proof film has a significant effect of enhancing the moisture proofness. According to the present invention, without the use of plural sheets of a high moisture proof film, which is expensive and is liable to be impaired in moisture proofness during processing, only a combination with a low moisture proof film, which is relatively inexpensive and has good handleability, may provide a large effect of enhancing the moisture proofness.

In this point of view, the water vapor transmission rate (WVTR (L)) of the moisture proof laminated film is preferably 80% or less, more preferably 75% or less, and further preferably 72% or less, of the value W.

The initial haze value of the moisture proof laminated film, which is obtained by the method described for the examples, is preferably 30 or less, and the rate of change in haze is preferably from 1 to 2, thereby providing the moisture proof laminated film that is excellent in transparency.

In the moisture proof laminated film of the present invention, the moisture proof film A and the moisture proof film B are laminated, and in the case where the moisture proof film A is a film containing a substrate having on one surface thereof an inorganic layer, the films are preferably laminated in such a manner that the inorganic layer of one of the moisture proof films is adhered to the substrate of the other moisture proof film from the viewpoint of long-term maintenance of the water proof performance. When the inorganic layers of the moisture proof films are adhered, water vapor penetrates from the side of the substrate of the moisture proof film to deteriorate the strength of the substrate through hydrolysis or the like, and thereby the adhesiveness of the inorganic layer to the substrate may be impaired, which may considerably deteriorate the moisture proofness. Accordingly, the inorganic layer is preferably adhered to the side where moisture penetrates (i.e., the exposure side).

The moisture proof laminated film of the present invention has an adhesive layer between the moisture proof film A and the moisture proof film B.

The adhesive used is preferably a polyurethane adhesive, and specific examples of the main agent of the adhesive include a polycarbonate polyol, a polyether polyol, an acrylic polyol, a polyurethane polyol and a polyester polyol. An adhesive containing at least one of a polycarbonate polyol, a polyether polyol and a polyurethane polyol is more preferred from the standpoint of the thermal stability, the moisture stability and the like.

The main agent of the adhesive preferably contains at least one of a polycarbonate polyol, a polyether polyol and a polyurethane polyol in an amount of from 20 to 70% by mass, and more preferably from 30 to 50% by mass. In the case where two or more kinds selected from a polycarbonate polyol, a polyether polyol and a polyurethane polyol are used in combination, the aforementioned content means the total amount thereof.

The polycarbonate polyol may be obtained, for example, from a diphenylcarbonate with a diol, such as ethylene glycol, propylene glycol, butanediol, neopentyl glycol (NPG) and cyclohexanediol, as raw materials.

The polyether polyol may be obtained, for example, by subjecting an alkylene oxide, such as ethylene oxide, propylene oxide and tetrahydrofuran, to ring-opening polymerization with a catalyst, such as an alkali catalyst and an acid catalyst. Examples of an active hydrogen-containing compound as a starting material of the ring-opening polymerization include a polyhydric alcohol, such as ethylene glycol, propylene glycol, 1,4-butanediol and 1,6-hexanediol.

The polyacrylic polyol may be obtained by copolymerizing a (meth)acrylate ester having a hydroxyl group with another monomer. Examples of the (meth)acrylate ester include hydroxyethyl acrylate, hydroxypropyl acrylate, hydroxybutyl acrylate, hydroxyethyl methacrylate, hydroxypropyl methacrylate, hydroxybutyl methacrylate, methyl methacrylate, butyl methacrylate and cyclohexyl methacrylate having an alicyclic structure. Preferred examples thereof include a polyacrylic polyol obtained by polymerizing such a monomer as methyl methacrylate, butyl methacrylate and cyclohexyl methacrylate having an alicyclic structure, and a polyacrylic polyol obtained by copolymerizing the monomers.

The polyurethane polyol may be obtained by subjecting a diol and a diisocyanate to urethanation reaction at a ratio of the hydroxyl group of 1 or more with respect to the isocyanate group. The diol component and the diisocyanate component as the components of the polyurethane polyol may be arbitrarily selected.

The diol component and the diisocyanate component may be selected in consideration of the flowability and the solubility in a solvent of the polyurethane polyol. Preferred examples of the diol component include a diol having a primary hydroxyl group, such as propylene glycol, tetramethylene glycol and neopentyl glycol. Examples of the isocyanate component include an aliphatic diisocyanate, an alicyclic diisocyanate and an aromatic diisocyanate.

Examples of the polyester polyol include compounds constituted by a dicarboxylic acid compound, such as succinic acid, glutaric acid, adipic acid, isophthalic acid (IPA) and terephthalic acid (TPA), and a diol, such as ethylene glycol, propylene glycol, butanediol, neopentyl glycol and cyclohexanediol, or polytetramethylene glycol.

An adhesive formed of a polyester polyol as a raw material is preferred due to the high adhesiveness to the substrate, and a polyester polyol that has a smaller number of ester bonds, which may be hydrolysis sites, is preferably selected for suppressing thermal deterioration caused by hydrolysis of the ester bonds. For example, a glycol having a long alkyl chain, such as neopentyl glycol (NPG), and a glycol having an alicyclic structure, such as 1,4-cyclohexanedimethanol, are preferably contained.

Furthermore, a hydrolysis resistant polyester polyol having a polyether structure in the main chain structure, such as polytetramethylene glycol (PTMG), may be preferably selected. The polyester polyol preferably has a molecular weight per one ester group of from 100 to 5,000, and more preferably from 120 to 3,000.

The curing agent used in the adhesive is preferably a diisocyanate, and examples thereof include an aliphatic compound, such as hexamethylene diisocyanate (HDI), an aromatic compound, such as xylylene diisocyanate (XDI) and diphenylmethane diisocyanate (MDI), and an alicyclic compound, such as isophorone diisocyanate (IPDI) and dicyclohexylmethane diisocyanate (H12MDI).

Preferred examples of the curing agent that imparts high heat resistance after curing include XDI, which is an aromatic diisocyanate, and IPDI, which is an alicyclic diisocyanate. For preventing the adhesive from being yellowed, IPDI, which is an alicyclic diisocyanate, and the like are more preferred.

In the case where the main agent contains a polycarbonate polyol, it is preferred to combine an HDI curing agent since high heat resistance and high moisture proofness may be obtained, and the adhesive may be difficult to be yellowed.

The main agent containing an epoxy compound may be used for providing an adhesive layer that is further thermally stable.

The mixing ratio of the main agent and the curing agent of the adhesive in the present invention may be from 5 to 25 in terms of mass ratio of (main agent) / (curing agent) or from 0. 8 to 9 in terms of molar ratio of functional groups (NCO) / (OH), from the point of reduce a residual reactive functional group in the adhesive.

In the case where the moisture proof laminated film of the present invention is used as a surface protective member for a solar cell, the moisture proof laminated film preferably has, in addition to the moisture proof film A and the moisture proof film B, a weather resistant film that is excellent in hydrolysis resistance and weather resistance, a backing film that ensures the adhesiveness to a sealing material and the withstand voltage, and the like. Specifically, it is preferred that a weather resistant film is provided on the side of the moisture proof film B, and a backing film or the like is provided on the side of the moisture proof film A, for providing high moisture proofness of the laminated material, and it is preferred to laminate the weather resistant film, the moisture proof film B, the moisture proof film A and the backing film in this order from the exposure side. In the present invention, it is also preferred that a weather resistant film is provided on the side of the moisture proof film A, and a backing film or the like is provided on the side of the moisture proof film B, for facilitating transmission of the residual solvent from the laminated material, and it is also a preferred embodiment that the weather resistant film, the moisture proof film A, the moisture proof film B and the backing film are laminated in this order from the exposure side. In the present invention, furthermore, it is preferred that the weather resistant film and the moisture proof film A or B, and the backing film and the moisture proof film A or B are each laminated through an adhesive layer, for ensuring the interlayer strength of the moisture proof laminated film.

While depending on the purpose, the moisture proof laminated film of the present invention is preferably transparent on application to a solar cell or the like, and may be arbitrarily combined with a non-transparent member.

### Weather Resistant Film

The weather resistant film is not particularly limited as far as the film has weather resistance, and preferred examples thereof include a film of a fluorine resin, such as polytetrafluoroethylene (PTFE), a tetrafluoroethylene-perfluoroalkyl vinyl ether copolymer (PFA), a tetrafluoroethylene-hexafluoropropylene copolymer (FEP), a tetrafluoroethylene-ethylene copolymer (ETFE), polychlorotrifluoroethylene (PCTFE), polyvinylidenefluoride (PVDF) and polyvinylfluoride (PVF), and a film formed with a resin composition containing a resin, such as acrylate, polycarbonate, polyethylene terephthalate (PET) and polyethylene naphthalate, and an ultraviolet ray absorbent mixed therein.

The resin used is more preferably a tetrafluoroethylene-ethylene copolymer (ETFE) and a tetrafluoroethylene-hexafluoropropylene copolymer (FEP) from the standpoint of the long-term durability.

A low shrinkable weather resistant material, such as polyethylene naphthalate, is preferred since it undergoes small change in characteristics on temperature and humidity change in vacuum lamination and under high temperature and high humidity condition. For a polyethylene terephthalate film and a fluorine-containing film, which have large shrinkage, a film having been subjected to a heat treatment in advance for decreasing shrinkage is preferably used.

In consideration of both the long-term durability and the shrinkage of the film, a film obtained with a resin composition containing a polyester resin, such as polyethylene terephthalate (PET) and polyethylene naphthalate (PEN), and an ultraviolet ray absorbent mixed therein, and a film obtained by providing a layer containing an ultraviolet ray absorbent to a film formed with a resin composition, such as a polyester resin, are preferably used.

In consideration of application to a protective member for a solar cell, the weather resistant film preferably has such property that has high flexibility and is excellent in heat resistance, moisture resistance and ultraviolet ray resistance, and a fluorine-containing film, a hydrolysis resistant polyester film containing an ultraviolet ray absorbent, and a film obtained by providing a layer containing an ultraviolet ray absorbent to a hydrolysis resistant polyester film are preferably used.

Examples of the ultraviolet ray absorbent used herein include those described for the substrate.

The amount of the ultraviolet ray absorbent added is generally approximately from 0.01 to 2.0% by mass, and preferably from 0.05 to 0.5% by mass, based on the weather resistant film.

Preferred examples of the weather stabilizer that imparts weather resistance in addition to the ultraviolet ray absorbent include a hindered amine light stabilizer. Examples of the hindered amine light stabilizer herein include those described for the substrate. The amount of the hindered amine light stabilizer added is generally approximately from 0.01 to 0.5% by mass, and preferably from 0. 05 to 0.3% by mass, based on the weather resistant film.

The thickness of the weather resistant film is generally approximately from 20 to 200 µm, and is preferably from 20 to 100 µm, and more preferably from 20 to 50 µm, from the standpoint of the handleability and the cost of the film.

### Backing Film

The temperature under which a solar cell is used is increased to approximately from 85 to 90°C due to the heat generated on power generation and the radiation heat of solar light, and if the melting point of the backing film is lower than that temperature, the backing film is softened and loses the intended function of protecting the solar cell device during operation. Accordingly, the backing film used is preferably a film formed with a resin composition containing a resin, such as polypropylene (PP), polylactic acid (PLA), polyvinyl fluoride (PVF), polyvinylidene fluoride (PVDF) and cellulose acetate butyrate (CAB), and an ultraviolet ray absorbent and a colorant kneaded therein, but is not limited thereto.

The backing film preferably has high flexibility and is excellent in ultraviolet ray resistance and moisture resistance on application to a surface protective member for a solar cell, and is preferably formed of a material mainly containing at least one of polypropylene, polylactic acid and polyvinylidene fluoride, and more preferably a material containing the resins in an amount of 50% by mass in total.

Examples of the ultraviolet ray absorbent herein include those described for the substrate. Examples of the colorant used include titanium oxide and calcium carbonate.

The thickness of the backing film is generally approximately from 25 to 300 µm, and is preferably from 50 to 300 µm, and more preferably from 50 to 250 µm, from the standpoint of the handleability and the cost of the film.

### Solar Cell Module and Production Method of Solar Cell

The moisture proof laminated film of the present invention may be used as a surface protective member for a solar cell, as it is or after laminating with a glass plate or the like. A solar cell module and/or a solar cell may be produced by using the surface protective member of the present invention according to a known method.

A solar cell module may be produced by using the surface protective member of the present invention in a layer structure of a surface protective member, such as an upper protective member or a lower protective member for a solar cell, and fixing a solar cell device along with a sealing material. Examples of the solar cell module include various types, for example, a structure containing an upper protective member (the surface protective member of the present invention) / a sealing material (a sealing resin layer) / a solar cell device / a sealing material (a sealing resin layer) / a lower protective member; a structure containing an upper protective member / a sealing material (a sealing resin layer) / a solar cell device / a sealing material (a sealing resin layer) / a lower protective member (the surface protective member of the present invention) ; a structure containing a lower protective member, a solar cell device formed on the inner periphery surface of the lower protective member, and a sealing material and an upper protective member (the surface protective member of the present invention) formed on the solar cell device; and a structure containing an upper protective member (the surface protective member of the present invention) and a solar cell device formed on the inner periphery surface of the upper protective member, for example, an amorphous solar cell device formed by sputtering or the like on a fluorine resin protective member, and a sealing material and a lower protective member formed thereon. A glass plate may be arbitrarily adhered to the outer surface of the surface protective member of the present invention as the upper protective member. In the case where the surface protective member including the sealing material and the surface protective member integrated is used, the sealing agent may not be used in some cases.

Examples of the solar cell device include an electric power generating device of a single crystal silicon type, a polycrystalline silicon type and an amorphous silicon type, a compound electric power generating device, such as a III-V Group or II-VI Group compound semiconductor type, e.g., gallium-arsenic, copper-indium-selenium and cadmium-tellurium, and a flexible electric power generating device, such as a dye sensitization type and an organic thin layer type.

The members constituting the solar cell module produced by using the surface protective member of the present invention are not particularly limited, and examples of the sealing material include an ethylene-vinyl acetate copolymer. The upper protective member and the lower protective member other than the surface protective member of the present invention may be a single layer or multilayer sheet of an inorganic material, such as a metal, or various thermoplastic resin films, and examples thereof include a single layer or multilayer protective member of a metal, such as tin, aluminum and stainless steel, an inorganic material, such as glass, a polyester, a polyester having an inorganic material vapor-deposited thereon, a fluorine-containing resin, a polyolefin or the like. The surface of the upper and/or lower protective members may be subjected to a known surface treatment, such as a primer treatment and a corona treatment, for enhancing the adhesiveness to the sealing material and the other members.

The solar cell module produced by using the surface protective member of the present invention is described with reference to a structure containing an upper protective member (the surface protective member of the present invention) / a sealing material / a solar cell device / a sealing material / a lower protective member, as an example. The surface protective member of the present invention, the sealing resin layer, the solar cell device, the sealing resin layer and the lower protective member are laminated in this order from the side receiving the solar light, and a junction box (i.e., a terminal box connected to wiring for extracting the electric power generated by the solar cell device) to the outside is adhered to the lower surface of the lower protective member. The solar cell device is connected to wiring for conducting the generated electric current to the outside. The wiring is drawn to the outside via a through hole provided on the back sheet and connected to the junction box.

The production method of the solar cell module may be a known production method without particular limitation, and in general, contains a step of laminating the upper protective member, the sealing material, the solar cell device, the sealing member and the lower protective member in this order, and a step of adhering them under heat and pressure by vacuum drawing. A batch production equipment and a roll-to-roll production equipment may be applied. Specifically, the solar cell module may be easily produced by adhering the upper protective member, the sealing material, the solar cell device, the sealing member and the lower protective member under heat and pressure according to an ordinary method with a vacuum laminator preferably at a temperature of from 130 to 180°C, and more preferably from 130 to 150°C, a vacuuming time of from 2 to 15 minutes, a pressing pressure of from 0.5 to 1 atm, and a pressing time of preferably from 8 to 45 minutes, and more preferably from 10 to 40 minutes.

The solar cell module produced by using the surface protective member of the present invention may be applied to various purposes including a small size solar cell, such as for a mobile equipment, and a large size solar cell mounted on a roof or a house top, irrespective of indoor or outdoor use, depending on the type of the solar cell and the shape of the module.

### Example

The present invention will be described more specifically with reference to examples below, but the present invention is not limited to the examples and comparative examples. The measurement and evaluation of the properties were performed in the following manners.

### Measurement of Properties

### (1) Moisture Proofness of Moisture Proof Film and Moisture Proof Laminated Film

### Measurement of Water Vapor Transmission Rate - Calculation from Weight Change of Bag

The moisture proof films a-1 to a-5 and a-7 were evaluated after storing at 40°C for one week from the production of the moisture proof films, and the moisture proof laminated films D-1, D-2, D-4, D-5, D-7 to D-10, and D-13 to D-15 were evaluated after dry lamination and aging, according to the following manner with reference to the conditions of JIS Z0222, test method for moisture permeability for moisture proof packaging container, and JIS Z0208, test method for moisture permeability for moisture proof packaging material (cup method).

Two sheets of the moisture proof films a-1 to a-5 and a-7 or the moisture proof laminated films D-1, D-2, D-4, D-5, D-7 to D-10, and D-13 to D-15 each having a moisture permeation area of a square of 10.0 cm x 10.0 cm were used, and a bag having been sealed on the four edges thereof containing approximately 20 g of anhydrous calcium chloride as a desiccant was produced with the inorganic vapor deposition layer directed outside for all the specimens. After placing the bag in a constant temperature and humidity chamber at a temperature of 40°C and a relative humidity of 90%, the mass thereof was measured with an interval of 72 hours or more for approximately 200 days, and the water vapor transmission rate (g/m²·day) was calculated from the slope of the regression curve of the elapsed time after 4 days and the weight of the bag.

### Measurement of Water Vapor Transmission Rate - Differential Pressure Method

Among the gas barrier films used in the solar cell modules, the films that had a water vapor transmission rate of less than 0.01 (g/m²·day) from the water vapor transmission rate measurement by the calculation from the weight change of the bag were subjected to the measurement of the water vapor transmission rate by a differential pressure method.

The moisture proof film a-6 was measured after storing at 40°C for one week from the production of the moisture proof films, and the moisture proof laminated films D-3, D-6, D-11 and D-12 were measured after dry lamination and aging, for the water vapor transmission rate with an equipment, DELTAPREM, produced by Technolox, Ltd. In the equipment, the laminated material is held between an upper chamber and a lower chamber, and the transmission of water vapor from the upper chamber in humidity condition to the lower chamber in vacuum condition is detected by the change in pressure, thereby providing the water vapor transmission rate (g/m²·day). The water vapor transmission rate was obtained by subtracting the measured value with both the upper chamber and the lower chamber being 40°C and 0%RH from the measured value with the upper chamber being 40°C and 90%RH and the lower chamber being 40°C and 0%RH after 2 weeks from the start of measurement.

### (2) Evaluation of Presence of Bubbles of Moisture Proof Laminated Film

The moisture proof laminated films D-1 to D-15 were each cut into a square of 10.0 cm × 10.0 cm and maintained in an oven at 150°C for 30 minutes, and the presence of bubbles was confirmed visually from the side opposite to the weather resistant film.
AA: no bubble observed over 10.0 cm × 10.0 cm square specimen
A: bubbles observed partly on 10.0 cm × 10.0 cm square specimen
B: bubbles observed over 10.0 cm × 10.0 cm square specimen

### (3) Measurement of Haze Value

The moisture proof laminated films D-1 to D-15 were each cut into a square of 15. 0 cm × 15.0 cm, and after heat-treating at 150°C for 30 minutes, measured for a haze value (initial haze value) of the moisture proof laminated film according to JIS K7136. The haze value was measured with a haze meter, NDH 2000, produced by Nippon Denshoku Industries Co., Ltd.

The moisture proof laminated films D-1 to D-15 thus cut and heat-treated were each subjected to a pressure cooker test as an accelerated test (at 120°C and humidity of 100% for 32 hours (PC32)) according to JIS C60068-2-66, and then measured for a haze value. The pressure cooker test was performed with a pressure cooker tester, LSK-500, produced by Tomy Seiko Co. , Ltd.

The rate of change in haze was calculated by (haze value after pressure cooker test (PC32)) / (initial haze value). In the case where no bubble occurs before and after the pressure cooker test (PC32), the rate of change in haze is 1 due to no change in haze.

### Constitutional Films

### Weather Resistant Film 1

A polyvinylidene fluoride (PVDF) film, Kynar 302-PGM-TR (thickness: 30 µm), produced by Arkema, Inc., was used.

### Moisture Proof Films

### Moisture Proof Film a-1

Techbarrier P2, produced by Mitsubishi Plastics, Inc., which was a 12 µm polyethylene terephthalate resin film having silica vapor-deposited thereon, was used as a moisture proof film a-1. The moisture proofness thereof measured by the aforementioned method was 0.610 (g/m²·day).

### Moisture Proof Film a-2

Techbarrier TX, produced by Mitsubishi Plastics, Inc., which was a 12 µm polyethylene terephthalate resin film having silica vapor-deposited thereon, was used as a moisture proof film a-2. The moisture proofness thereof measured by the aforementioned method was 0.400 (g/m²·day).

### Moisture Proof Film a-3

Techbarrier LX, produced by Mitsubishi Plastics, Inc., which was a 12 µm polyethylene terephthalate resin film having silica vapor-deposited thereon, was used as a moisture proof film a-3. The moisture proofness thereof measured by the aforementioned method was 0.200 (g/m²·day).

### Moisture Proof Film a-4

A biaxially stretched polyethylene naphthalate film having a thickness of 12 µm (Q51C12, produced by Teij in DuPont Films Japan Ltd.) was used as a substrate, and the following coating composition was coated on the corona-treated surface thereof and dried to form a coating layer having a thickness of 0.1 µm.

Thereafter, SiO was evaporated under heating in vacuum of 1.33 × 10⁻³ Pa (1 × 10⁻⁵ Torr) with a vacuum vapor deposition equipment, thereby providing a moisture proof film a-4 having an SiOₓ inorganic layer (x = 1.5) having a thickness of 40 nm on the coating layer. The moisture proofness of the moisture proof film a-4 thus produced was 0.015 (g/m²·day).

### Moisture Proof Film a-5

A biaxially stretched polyethylene naphthalate film having a thickness of 12 µm (Q51C12, produced by Teij in DuPont Films Japan Ltd.) was used as a substrate, and the following coating composition was coated on the corona-treated surface thereof and dried to form a coating layer having a thickness of 0.1 µm.

Thereafter, SiO was evaporated under heating in vacuum of 1.33 × 10⁻³ Pa (1 × 10⁻⁵ Torr) with a vacuum vapor deposition equipment, thereby providing a moisture proof film a-5 having an SiOₓ inorganic layer (x = 1.5) having a thickness of 15 nm on the coating layer. The moisture proofness of the moisture proof film a-5 thus produced was 0.040 (g/m²·day).

### Moisture Proof Film a-6

A biaxially stretched polyethylene naphthalate film having a thickness of 12 µm (Q51C12, produced by Teij in DuPont Films Japan Ltd.) was used as a substrate, and SiO was evaporated in vacuum with a vacuum vapor deposition equipment, thereby forming a vacuum deposition layer of SiOₓ (i.e. , a PVD inorganic layer) having a thickness of 50 nm. Thereafter, a plasma chemical vapor deposition layer (i.e., a CVD inorganic film) having a thickness of 3 nm was formed on the surface of the inorganic layer with HMDSN (hexamethyldisilazane) under plasma with argon gas introduced. Thereafter, SiO was evaporated in vacuum, thereby forming a PVD inorganic layer of SiOₓ having a thickness of 50 nm on the plasma CVD inorganic layer, and thus a moisture proof film a-6 was provided.

The moisture proofness of the moisture proof film a-6 thus produced was 0.0030 (g/m²·day).

### Moisture Proof Film a-7

An ethylene-norbornene random copolymer (TOPAS 9506X1, a trade name, produced by Polyplastics Co., Ltd., norbornene content: 22% by mol) as a cyclic olef in polymer was melt-kneaded with a 32 mm single screw extruder with a T-die set at a temperature of 260°C, and formed into a film by quenching with a cast roll at 20°C, thereby providing a cyclic olefin moisture proof film (COC) having a thickness of 0.5 mm. The moisture proofness thereof measured by the aforementioned method was 0.500 (g/m²·day).

### Coating Composition

220 g of a polyvinyl alcohol resin, Gohsenol, produced by Nippon Synthetic Chemical Industry Co., Ltd. (saponification degree: 97.0 to 98.8% by mol, polymerization degree: 2,400), was added to 2,810 g of ion exchanged water and dissolved therein under heating to form an aqueous solution, to which 645 g of 35% hydrochloric acid was added at 20°C under stirring. Thereafter, 3.6 g of butylaldehyde was added thereto at 10°C under stirring, and after 5 minutes, 143 g of acetaldehyde was added thereto under stirring to deposit resin fine particles. Thereafter, the liquid was maintained at 60°C for 2 hours, then cooled, neutralized with sodium hydrogen carbonate, rinsed with water, and dried, thereby providing polyvinyl acetacetal resin powder (acetalization degree: 75% by mol).

An isocyanate resin (Sumidur N-3200, produced by Sumika Bayer Urethane Co., Ltd.) as a crosslinking agent was mixed to make an equivalent ratio of isocyanate groups to hydroxyl groups of 1/2.

[Table 1]

**Table 1**

| Moisture proof film | Moisture proofness (g/m²·day) |
|---|---|
| a-1 | 0.610 |
| a-2 | 0.400 |
| a-3 | 0.200 |
| a-4 | 0.015 |
| a-5 | 0.040 |
| a-6 | 0.0030 |
| a-7 | 0.500 |

### Adhesive Coating Composition

HD 1013 , produced by Rock Paint Co. , Ltd. , as a main agent containing a polyurethane polyol component and H62, produced by Rock Paint Co., Ltd., as a curing agent containing a hexamethylene diisocyanate component, which was an aliphatic compound, were mixed to make a mass ratio of 10/1, and diluted with ethyl acetate to make a solid concentration of 30%, thereby providing an adhesive coating composition. The adhesive coating composition was coated on a 50 µm PET film, which was then adhered to the moisture proof films a-1 to a-7, followed by aging, and the water vapor transmission rates thereof were measured for confirming that the adhesive had no effect of enhancing the moisture proofness of the moisture proof films a-1 to a-7.

### Example 1

The adhesive coating composition was coated on the weather resistant film 1 and dried to make a solid content of 6 g/m², to which the moisture proof film a-4 used as the moisture proof film B was adhered by dry lamination, with the inorganic layer of the moisture proof film a-4 being directed to the adhesive surface.

Thereafter, the adhesive coating composition was coated on the substrate of the moisture proof film a-4 of the laminated film and dried to make a solid content of 6 g/m², to which the moisture proof film a-1 used as the moisture proof film A was adhered, with the inorganic layer of the moisture proof film a-1 being directed to the adhesive surface, followed by aging at 40°C for 5 days, thereby providing a moisture proof laminated film D-1 having a thickness of 66 µm, which was measured and evaluated for the moisture proofness, the presence of bubbles and the rate of change in haze. The results are shown in Table 2.

### Example 2

A moisture proof laminated film D-2 having a thickness of 66 µm was produced in the same manner as in Example 1 except that the moisture proof film a-2 was used as the moisture proof film A, and measured and evaluated for the moisture proof ness, the presence of bubbles and the rate of change in haze. The results are shown in Table 2.

### Example 3

A moisture proof laminated film D-3 having a thickness of 66 µm was produced in the same manner as in Example 1 except that the moisture proof film a-3 was used as the moisture proof film A, and measured and evaluated for the moisture proof ness, the presence of bubbles and the rate of change in haze. The results are shown in Table 2.

### Example 4

The moisture proof film on the side of the weather resistant film in Example 3 was replaced.

Specifically, the adhesive coating composition was coated on the weather resistant film 1 and dried to make a solid content of 6 g/m², to which the moisture proof film a-3 used as the moisture proof film A was adhered by dry lamination, with the inorganic layer of the moisture proof film a-3 being directed to the adhesive surface.

Thereafter, the adhesive coating composition was coated on the substrate of the moisture proof film a-3 of the laminated film and dried to make a solid content of 6 g/m², to which the moisture proof film a-4 used as the moisture proof film B was adhered, with the inorganic layer of the moisture proof film a-4 being directed to the adhesive surface, followed by aging at 40°C for 5 days, thereby providing a moisture proof laminated film D-4 having a thickness of 66 µm, which was measured and evaluated for the moisture proofness, the presence of bubbles and the rate of change in haze. The results are shown in Table 2.

### Example 5

A moisture proof laminated film D-5 having a thickness of 66 µm was produced in the same manner as in Example 1 except that the moisture proof film a-2 was used as the moisture proof film A, and the moisture proof film a-5 was used as the moisture proof film B, and measured and evaluated for the moisture proofness, the presence of bubbles and the rate of change in haze. The results are shown in Table 2.

### Example 6

A moisture proof laminated film D-6 having a thickness of 66 µm was produced in the same manner as in Example 1 except that the moisture proof film a-3 was used as the moisture proof film A, and the moisture proof film a-6 was used as the moisture proof film B, and measured and evaluated for the moisture proofness, the presence of bubbles and the rate of change in haze. The results are shown in Table 2.

### Example 7

A moisture proof laminated film D-7 having a thickness of 554 µm was produced in the same manner as in Example 1 except that the moisture proof film a-7 was used as the moisture proof film A, and measured and evaluated for the moisture proofness, the presence of bubbles and the rate of change in haze. The results are shown in Table 2.

### Example 8

The moisture proof film on the side of the weather resistant film in Example 7 was replaced.

Specifically, the adhesive coating composition was coated on the weather resistant film 1 and dried to make a solid content of 6 g/m², to which the moisture proof film a-7 used as the moisture proof film A was adhered by dry lamination, with the inorganic layer of the moisture proof film a-7 being directed to the adhesive surface.

Thereafter, the adhesive coating composition was coated on the substrate of the moisture proof film a-7 of the laminated film and dried to make a solid content of 6 g/m², to which the moisture proof film a-4 used as the moisture proof film B was adhered, with the inorganic layer of the moisture proof film a-4 being directed to the adhesive surface, followed by aging at 40°C for 5 days, thereby providing a moisture proof laminated film D-8 having a thickness of 554 µm, which was measured and evaluated for the moisture proofness, the presence of bubbles and the rate of change in haze. The results are shown in Table 2.

### Comparative Example 1

A moisture proof laminated film D-9 having a thickness of 66 µm was produced in the same manner as in Example 1 except that the moisture proof film a-3 was used as both the moisture proof film A and the moisture proof film B, and measured and evaluated for the moisture proof ness, the presence of bubbles and the rate of change in haze. The results are shown in Table 2.

### Comparative Example 2

A moisture proof laminated film D-10 having a thickness of 66 µm was produced in the same manner as in Example 1 except that the moisture proof film a-3 was used as the moisture proof film B, and the moisture proof film a-2 was used as the moisture proof film A, and measured and evaluated for the moisture proofness, the presence of bubbles and the rate of change in haze. The results are shown in Table 2.

### Comparative Example 3

A moisture proof laminated film D-11 having a thickness of 66 µm was produced in the same manner as in Example 1 except that the moisture proof film a-4 was used as both the moisture proof film A and the moisture proof film B, and measured and evaluated for the moisture proofness, the presence of bubbles and the rate of change in haze. The results are shown in Table 2.

### Comparative Example 4

A moisture proof laminated film D-12 having a thickness of 66 µm was produced in the same manner as in Example 1 except that the moisture proof film a-6 was used as the moisture proof film B, and the moisture proof film a-4 was used as the moisture proof film A, and measured and evaluated for the moisture proofness, the presence of bubbles and the rate of change in haze. The results are shown in Table 2.

### Comparative Example 5

A moisture proof laminated film D-13 having a thickness of 554 µm was produced in the same manner as in Example 1 except that the moisture proof film a-3 was used as the moisture proof film B, and the moisture proof film a-7 was used as the moisture proof film A, and measured and evaluated for the moisture proofness, the presence of bubbles and the rate of change in haze. The results are shown in Table 2.

### Comparative Example 6

A moisture proof laminated film D-14 having a thickness of 554 µm was produced in the same manner as in Example 1 except that the moisture proof film a-2 was used as the moisture proof film B, and the moisture proof film a-7 was used as the moisture proof film A, and measured and evaluated for the moisture proofness, the presence of bubbles and the rate of change in haze. The results are shown in Table 2.

### Comparative Example 7

The moisture proof film on the side of the weather resistant film in Comparative Example 5 was replaced.

Specifically, the adhesive coating composition was coated on the weather resistant film 1 and dried to make a solid content of 6 g/m², to which the moisture proof film a-7 used as the moisture proof film A was adhered by dry lamination, with the inorganic layer of the moisture proof film a-7 being directed to the adhesive surface.

Thereafter, the adhesive coating composition was coated on the substrate of the moisture proof film a-7 of the laminated film and dried to make a solid content of 6 g/m², to which the moisture proof film a-3 used as the moisture proof film B was adhered, with the inorganic layer of the moisture proof film a-3 being directed to the adhesive surface, followed by aging at 40°C for 5 days, thereby providing a moisture proof laminated film D-15 having a thickness of 554 µm, which was measured and evaluated for the moisture proofness, the presence of bubbles and the rate of change in haze. The results are shown in Table 2.

[Table 2]

**Table 2**

| | Moisture Proof Laminated Film | On the side of weather resistant film | | | | (Moisture proofness of moisture proof film B) / (moisture proofness of moisture proof film A) (%) | Moisture proofness (WVTR (L)) (g/m² · day) | W = ((WTR (A)) × (WTR (B))) / ((WTR (A)) + (WTR (B))) | Presence of bubbles | Rate of change in haze |
|---|---|---|---|---|---|---|---|---|---|---|
| | | Kind of moisture proof film* | Moisture proofness (WTR) (g/m²·day) | Kind of moisture proof film* | Moisture proofness (WTR) (g/m²·day) | | | | | |
| Example 1 | D-1 | a-4 (B) | 0.015 | a-1 (A) | 0.610 | 2.5 | 0.010 | 0.015 | AA | 1 |
| Example 2 | D-2 | a-4 (B) | 0.015 | a-2 (A) | 0.400 | 3.8 | 0.010 | 0.014 | AA | 1 |
| Example 3 | D-3 | a-4 (B) | 0.015 | a-3 (A) | 0.200 | 7.5 | 0.0090 | 0.014 | A | 1 |
| Example 4 | D-4 | a-3 (A) | 0.200 | a-4 (B) | 0.015 | 7.5 | 0.010 | 0.014 | A | 1 |
| Example 5 | D-5 | a-5 (B) | 0.040 | a-2 (A) | 0.400 | 10 | 0.028 | 0.036 | AA | 1 |
| Example 6 | D-6 | a-6 (B) | 0.0030 | a-3 (A) | 0.200 | 1.5 | 0.0010 | 0.0030 | A | 1 |
| Example 7 | D-7 | a-4 (B) | 0.015 | a-7 (A) | 0.500 | 3.0 | 0.011 | 0.015 | A | 1 |
| Example 8 | D-8 | a-7 (A) | 0.500 | a-4 (B) | 0.015 | 3.0 | 0.012 | 0.015 | AA | 1 |
| Comparative Example 1 | D-9 | a-3 | 0.200 | a-3 | 0.200 | 100 | 0.100 | 0.100 | AA | 1 |
| Comparative Example 2 | D-10 | a-3 (B) | 0.200 | a-2 (A) | 0.400 | 50 | 0.140 | 0.133 | AA | 1 |
| Comparative Example 3 | D-11 | a-4 | 0.015 | a-4 | 0.015 | 100 | 0.0070 | 0.0075 | B | 3 |
| Comparative Example 4 | D-12 | a-6 (B) | 0.0030 | a-4 (A) | 0.015 | 20 | 0.0008 | 0.0025 | B | 3 |
| Comparative Example 5 | D-13 | a-3 (B) | 0.200 | a-7 (A) | 0.500 | 40 | 0.140 | 0.140 | AA | 1 |
| Comparative Example 6 | D-14 | a-2 (B) | 0.400 | a-7 (A) | 0.500 | 80 | 0.220 | 0.220 | AA | 1 |
| Comparative Example 7 | D-15 | a-7 (A) | 0.500 | a-3 (B) | 0.200 | 40 | 0.150 | 0.140 | AA | 1 |

| | | | | | | | | | | |
|---|---|---|---|---|---|---|---|---|---|---|
| Note: * (A) shows the moisture proof film A, and (B) shows the moisture proof film B. | | | | | | | | | | |

Examples 1 to 8, which related to the moisture proof laminated films D-1 to D-8 having water vapor transmission rates of the moisture proof film A and the moisture proof film B within the ranges defined in the present invention, all were excellent in moisture proofness and prevention of generation of bubbles, and were excellent in transparency without deterioration of haze. Comparative Examples 1, 2 and 5 to 7 having a water vapor transmission rate of the moisture proof film corresponding to the moisture proof film B outside the range defined in the present invention were suppressed in generation of bubbles, but exhibited such water proofness that the water vapor transmission rate (WTR (L)) of the moisture proof laminated film at 40°C and 90%RH was equivalent to the theoretically derived value W. In Comparative Example 3, in which the moisture proof films corresponding to the moisture proof film A and the moisture proof film B had the same low water vapor transmission rates, and Comparative Example 4, in which the moisture proof films each had a low water vapor transmission rate, the resulting moisture proof laminated films exhibited good moisture proofness, but bubbles remained therein.

### Reference Signs List

- 1: moisture proof laminated film
- 2: moisture proof film A
- 3: moisture proof film B
- 4: substrate
- 5: inorganic layer
- 6: weather resistant film
- 7: adhesive layer
- 8: backing film

## Claims

1. A moisture proof laminated film comprising a moisture proof film A having a water vapor transmission rate (WTR (A)) at 40°C and 90%RH of 1.0 (g/m²·day) or less and a moisture proof film B comprising a substrate having on one surface thereof an inorganic layer, which are laminated through an adhesive layer, wherein the moisture proof laminated film satisfies (i) or (ii):
(i) the water vapor transmission rate (WTR (B)) of film B at 40°C and 90%RH is 10% or less of the water vapor transmission rate (WTR (A)) of film A;
(ii) the water vapor transmission rate (WTR (A)) of film A at 40°C and 90%RH is 0.1 (g/m²·day) or more and 1.0 (g/m²·day) or less, and the water vapor transmission rate (WTR (B)) of film B at 40°C and 90%RH is 0.001 (g/m²·day) or more and less than 0.1 (g/m²·day)

2. The moisture proof laminated film according to claim 1 , wherein the moisture proof laminated film has a water vapor transmission rate (WVTR (L)) at 40°C and 90%RH that is lower than a value ((WTR (A)) × (WTR (B))) / ((WTR (A)) + (WTR (B))).

3. The moisture proof laminated film according to any one of claims 1 or 2, wherein the moisture proof laminated film has a water vapor transmission rate (WVTR (L)) at 40°C and 90%RH that is 80% or less of a value ((WTR (A)) × (WTR (B))) / ((WTR (A)) + (WTR (B))).

4. The moisture proof laminated film according to any one of claims 1, 2 and 3, wherein the water vapor transmission rate (WTR (A)) at 40°C and 90%RH of the moisture proof film A is 0.1 (g/m²·day) or more.

5. The moisture proof laminated film according to any one of claims 1 to 4, wherein the water vapor transmission rate (WTR (A)) at 40°C and 90%RH of the moisture proof film A is 0.2 (g/m²·day) or more.

6. The moisture proof laminated film according to any one of claims 1 to 5, wherein the water vapor transmission rate (WTR (A)) at 40°C and 90%RH of the moisture proof film A is 0.4 (g/m²·day) or more.

7. The moisture proof laminated film according to any one of claims 1 to 6, wherein the water vapor transmission rate (WTR (A)) at 40°C and 90%RH of the moisture proof film A is 0.6 (g/m²·day) or more.

8. The moisture proof laminated film according to any one of claims 1 and 2 to 7, wherein the water vapor transmission rate (WTR (B)) at 40°C and 90%RH of the moisture proof film B is 0.001 (g/m²·day) or more and 0.1 (g/m²·day) or less.

9. The moisture proof laminated film according to any one of claims 1 to 8, wherein the water vapor transmission rate (WTR (B)) at 40°C and 90%RH of the moisture proof film B is 0.001 (g/m²·day) or more and 0.05 (g/m²·day) or less.

10. The moisture proof laminated film according to any one of claims 1 to 9, wherein the moisture proof film A has at least one layer containing a resin composition containing a cyclic olefin polymer.

11. The moisture proof laminated film according to any one of claims 1 to 9, wherein the moisture proof film A comprises a substrate having on one surface thereof an inorganic layer.

12. The moisture proof laminated film according to claim 11, wherein the moisture proof laminated film comprises a weather resistant film, the moisture proof film B and the moisture proof film A in this order from an exposure side, and the substrate of the moisture proof film B is disposed on a side of the inorganic layer of the moisture proof film A.

13. The moisture proof laminated film according to claim 11, wherein the moisture proof laminated film comprises a weather resistant film, the moisture proof film A and the moisture proof film B in this order from an exposure side, and the substrate of the moisture proof film A is disposed on a side of the inorganic layer of the moisture proof film B.

14. The moisture proof laminated film according to any one of claims 1 to 13, wherein the adhesive layer contains an adhesive, and the adhesive contains as a main agent at least one of a polycarbonate polyol, a polyether polyol, an acrylic polyol, a polyurethane polyol and a polyester polyol.

15. A surface protective member for a solar cell, comprising the moisture proof laminated film according to any one of claims 1 to 14.

16. The surface protective member for a solar cell according to claim 15, wherein the moisture proof film A and the moisture proof film B each have an inorganic layer on an exposure side.

17. A solar cell module produced by using the surface protective member for a solar cell according to claims 15 or 16, wherein the solar cell module preferably has a compound power generating device or is a flexible solar cell module.

## Patentansprüche

1. Feuchtigkeitsfeste Laminatfolie, umfassend eine feuchtigkeitsfeste Folie (A) mit einer Wasserdampf-Transmissionsrate (WTR (A)) bei 40°C und 90 % relativer Luftfeuchtigkeit von 1,0 (g/m²·Tag) oder weniger, und eine feuchtigkeitsfest Folie (B), umfassend ein Substrat, das auf einer Oberfläche hiervon eine anorganische Schicht aufweist, welche durch eine Adhäsivschicht laminiert sind, worin die feuchtigkeitsfeste Laminatfolie (i) oder (ii) erfüllt:
(i) die Wasserdampf-Transmissionsrate (WTR (B)) der Folie (B) bei 40°C und 90 % relativer Luftfeuchtigkeit beträgt 10 % oder weniger der Wasserdampf-Transmissionsrate (WTR (A)) der Folie (A) ;
(ii) die Wasserdampf-Transmissionsrate (WTR (A)) der Folie (A) bei 40°C und 90 % relativer Luftfeuchtigkeit beträgt 0,1 (g/m²·Tag) oder mehr und 1,0 (g/m²·Tag) oder weniger, und die Wasserdampf-Transmissionsrate (WTR (B)) der Folie (B) bei 40°C und 90 % relativer Luftfeuchtigkeit beträgt 0,001 (g/m²·Tag) oder mehr und weniger als 0,1 (g/m²·Tag)

2. Feuchtigkeitsfeste Laminatfolie gemäß Anspruch 1, worin die feuchtigkeitsfeste Laminatfolie eine Wasserdampf-Transmissionsrate (WVTR (L)) bei 40°C und 90 % relativer Luftfeuchtigkeit aufweist, die niedriger ist als ein Wert ((WTR (A))) × (WTR (B)))/((WTR (A)) + (WTR (B))).

3. Feuchtigkeitsfeste Laminatfolie gemäß irgendeinem der Ansprüche 1 oder 2, worin die feuchtigkeitsfeste Laminatfolie eine Wasserdampf-Transmissionsrate (WVTR (L)) bei 40°C und 90 % relativer Luftfeuchtigkeit aufweist, die 80 % oder weniger eines Werts ((WTR (A)) x (WTR (B)))/((WTR (A)) + (WTR (B))) beträgt.

4. Feuchtigkeitsfeste Laminatfolie gemäß irgendeinem der Ansprüche 1, 2 und 3, worin die Wasserdampf-Transmissionsrate (WTR (A)) bei 40°C und 90 % relativer Luftfeuchtigkeit der feuchtigkeitsfesten Folie (A) 0,1 (g/m²·Tag) oder mehr beträgt.

5. Feuchtigkeitsfeste Laminatfolie gemäß irgendeinem der Ansprüche 1 bis 4, worin die Wasserdampf-Transmissionsrate (WTR (A)) bei 40°C und 90 % relativer Luftfeuchtigkeit der feuchtigkeitsfesten Folie (A) 0,2 (g/m²·Tag) oder mehr beträgt.

6. Feuchtigkeitsfeste Laminatfolie gemäß irgendeinem der Ansprüche 1 bis 5, worin die Wasserdampf-Transmissionsrate (WTR (A)) bei 40°C und 90 % relativer Luftfeuchtigkeit der feuchtigkeitsfesten Folie (A) 0,4 (g/m²·Tag) oder mehr beträgt.

7. Feuchtigkeitsfeste Laminatfolie gemäß irgendeinem der Ansprüche 1 bis 6, worin die Wasserdampf-Transmissionsrate (WTR (A)) bei 40°C und 90 % relativer Luftfeuchtigkeit der feuchtigkeitsfesten Folie (A) 0,6 (g/m²·Tag) oder mehr beträgt.

8. Feuchtigkeitsfeste Laminatfolie gemäß irgendeinem der Ansprüche 1 und 2 bis 7, worin die Wasserdampf-Transmissionsrate (WTR (B)) bei 40°C und 90 % relativer Luftfeuchtigkeit der feuchtigkeitsfesten Folie (B) 0,001 (g/m²·Tag) oder mehr und 0,1 (g/m²·Tag) oder weniger beträgt.

9. Feuchtigkeitsfeste Laminatfolie gemäß irgendeinem der Ansprüche 1 bis 8, worin die Wasserdampf-Transmissionsrate (WTR (B)) bei 40°C und 90 % relativer Luftfeuchtigkeit der feuchtigkeitsfesten Folie (B) 0,001 (g/m²·Tag) oder mehr und 0,05 (g/m²·Tag) oder weniger beträgt.

10. Feuchtigkeitsfeste Laminatfolie gemäß irgendeinem der Ansprüche 1 bis 9, worin die feuchtigkeitsfeste Folie (A) mindestens eine Schicht aufweist, die eine Harzzusammensetzung enthält, die ein Polymer eines cyclischen Olefins enthält.

11. Feuchtigkeitsfeste Laminatfolie gemäß irgendeinem der Ansprüche 1 bis 9, worin die feuchtigkeitsfeste Folie (A) ein Substrat umfasst, das auf einer Oberfläche hiervon eine anorganische Schicht aufweist.

12. Feuchtigkeitsfeste Laminatfolie gemäß Anspruch 11, worin die feuchtigkeitsfeste Laminatfolie eine wetterfeste Folie umfasst, worin die feuchtigkeitsfeste Folie (B) und die feuchtigkeitsfeste Folie (A) in dieser Reihenfolge von einer freiliegenden Seite aus angeordnet sind, und worin das Substrat der feuchtigkeitsfesten Folie (B) auf einer Seite der anorganischen Schicht der feuchtigkeitsfesten Folie (A) angeordnet ist.

13. Feuchtigkeitsfeste Laminatfolie gemäß Anspruch 11, worin die feuchtigkeitsfeste Laminatfolie eine wetterfeste Folie umfasst, worin die feuchtigkeitsfeste Folie (A) und die feuchtigkeitsfeste Folie (B) in dieser Reihenfolge von der freiliegenden Seite angeordnet sind, und das Substrat der feuchtigkeitsfesten Folie (A) auf einer Seite der anorganischen Schicht der feuchtigkeitsfesten Folie (B) angeordnet ist.

14. Feuchtigkeitsfeste Laminatfolie gemäß irgendeinem der Ansprüche 1 bis 13, worin die Adhäsivschicht ein Adhäsiv enthält, und worin das Adhäsiv als Hauptmittel zumindest eines von einem Polycarbonatpolyol, einem Polyetherpolyol, einem Acrylpolyol, einem Polyurethanpolyol und einem Polyesterpolyol umfasst.

15. Oberflächenschutzbauteil für eine Solarzelle, umfassend die feuchtigkeitsfeste Laminatfolie gemäß irgendeinem der Ansprüche 1 bis 14.

16. Oberflächenschutzbauteil für eine Solarzelle gemäß Anspruch 15, worin die feuchtigkeitsfeste Folie (A) und die feuchtigkeitsfeste Folie (B) jeweils eine anorganische Schicht auf einer freiliegenden Seite aufweisen.

17. Solarzellenmodul, hergestellt unter Verwendung des Oberflächenschutzbauteils für eine Solarzelle gemäß den Ansprüchen 15 oder 16, worin das Solarzellenmodul bevorzugt eine Kraft-generierende Vorrichtung einer Verbindung aufweist oder ein flexibles Solarzellenmodul ist.

## Revendications

1. Film stratifié résistant à l'humidité, comprenant un film A résistant à l'humidité présentant un coefficient de transmission de la vapeur d'eau (WTR (A)) à 40 °C et à une HR de 90 % de 1,0 (g/m².jour) ou moins et un film B résistant à l'humidité comprenant un substrat comportant, sur l'une de ses surfaces, une couche inorganique, qui sont stratifiés via une couche adhésive, dans lequel le film stratifié résistant à l'humidité satisfait à (i) ou (ii) :
(i) le coefficient de transmission de la vapeur d'eau (WTR (B)) du film B à 40 °C et à une HR de 90 % représente 10 % ou moins du coefficient de transmission de la vapeur d'eau (WTR (A)) du film A ;
(ii) le coefficient de transmission de la vapeur d'eau (WTR (A)) du film A à 40 °C et à une HR de 90 % est de 0,1 (g/m².jour) ou plus et de 1,0 (g/m².jour) ou moins, et le coefficient de transmission de la vapeur d'eau (WTR (B)) du film B à 40 °C et à une HR de 90 % est de 0,001 (g/m².jour) ou plus et de moins de 0,1 (g/m².jour).

2. Film stratifié résistant à l'humidité selon la revendication 1, dans lequel le film stratifié résistant à l'humidité présente un coefficient de transmission de la vapeur d'eau (WVTR (L)) à 40 °C et à une HR de 90 % qui est inférieur à une valeur ((WTR (A)) x (WTR (B)))/((WTR (A)) + (WTR (B))).

3. Film stratifié résistant à l'humidité selon l'une quelconque des revendications 1 ou 2, dans lequel le film stratifié résistant à l'humidité présente un coefficient de transmission de la vapeur d'eau (WVTR (L)) à 40 °C et à une HR de 90 % qui représente 80 % ou moins d'une valeur ((WTR (A)) x (WTR (B)))/((WTR (A)) + (WTR (B))).

4. Film stratifié résistant à l'humidité selon l'une quelconque des revendications 1, 2 et 3, dans lequel le coefficient de transmission de la vapeur d'eau (WTR (A)) à 40 °C et à une HR de 90 % du film A résistant à l'humidité est de 0,1 (g/m².jour) ou plus.

5. Film stratifié résistant à l'humidité selon l'une quelconque des revendications 1 à 4, dans lequel le coefficient de transmission de la vapeur d'eau (WTR (A)) à 40 °C et à une HR de 90 % du film A résistant à l'humidité est de 0,2 (g/m².jour) ou plus.

6. Film stratifié résistant à l'humidité selon l'une quelconque des revendications 1 à 5, dans lequel le coefficient de transmission de la vapeur d'eau (WTR (A)) à 40 °C et à une HR de 90 % du film A résistant à l'humidité est de 0,4 (g/m².jour) ou plus.

7. Film stratifié résistant à l'humidité selon l'une quelconque des revendications 1 à 6, dans lequel le coefficient de transmission de la vapeur d'eau (WTR (A)) à 40 °C et à une HR de 90 % du film A résistant à l'humidité est de 0,6 (g/m².jour) ou plus.

8. Film stratifié résistant à l'humidité selon l'une quelconque des revendications 1 et 2 à 7, dans lequel le coefficient de transmission de la vapeur d'eau (WTR (B)) à 40 °C et à une HR de 90 % du film B résistant à l'humidité est de 0,001 (g/m².jour) ou plus et de 0,1 (g/m².jour) ou moins.

9. Film stratifié résistant à l'humidité selon l'une quelconque des revendications 1 à 8, dans lequel le coefficient de transmission de la vapeur d'eau (WTR (B)) à 40 °C et à une HR de 90 % du film B résistant à l'humidité est de 0,001 (g/m².jour) ou plus et de 0,05 (g/m².jour) ou moins.

10. Film stratifié résistant à l'humidité selon l'une quelconque des revendications 1 à 9, dans lequel le film A résistant à l'humidité comporte au moins une couche contenant une composition de résine contenant un polymère d'oléfine cyclique.

11. Film stratifié résistant à l'humidité selon l'une quelconque des revendications 1 à 9, dans lequel le film A résistant à l'humidité comprend un substrat ayant une couche inorganique sur l'une de ses surfaces.

12. Film stratifié résistant à l'humidité selon la revendication 11, dans lequel le film stratifié résistant à l'humidité comprend un film résistant aux intempéries, le film B résistant à l'humidité et le film A résistant à l'humidité dans cet ordre à partir d'une face d'exposition, et le substrat du film B résistant à l'humidité est disposé sur une face de la couche inorganique du film A résistant à l'humidité.

13. Film stratifié résistant à l'humidité selon la revendication 11, dans lequel le film stratifié résistant à l'humidité comprend un film résistant aux intempéries, le film A résistant à l'humidité et le film B résistant à l'humidité dans cet ordre à partir d'une face d'exposition, et le substrat du film A résistant à l'humidité est disposé sur une face de la couche inorganique du film B résistant à l'humidité.

14. Film stratifié résistant à l'humidité selon l'une quelconque des revendications 1 à 13, dans lequel la couche adhésive contient un adhésif et l'adhésif contient comme agent principal au moins un ou l'autre d'un polycarbonate polyol, d'un polyéther polyol, d'un polyol acrylique, d'un polyuréthane polyol et d'un polyester polyol.

15. Elément protecteur de surface pour pile solaire, comprenant le film stratifié résistant à l'humidité selon l'une quelconque des revendications 1 à 14.

16. Elément protecteur de surface pour pile solaire selon la revendication 15, dans lequel le film A résistant à l'humidité et le film B résistant à l'humidité comportent chacun une couche inorganique sur une face d'exposition.

17. Module de pile solaire produit par l'utilisation de l'élément protecteur de surface pour pile solaire selon la revendication 15 ou 16, dans lequel le module de pile solaire comporte de préférence un dispositif de génération d'énergie composite ou est un module flexible de pile solaire.
